# EUROPEAN PATENT APPLICATION

(11) **EP 4 841 889 A1**
(43) Date of publication of application: **18.11.2026**
(21) Application number: 26156373.8
(22) Date of filing: 04.02.2026
(51) Int. Cl.: H03F 1/42, H03F 3/08, H03F 3/45

(54) **BANDWIDTH-ENHANCED DIFFERENTIAL TRANSIMPEDANCE AMPLIFIERS**

(30) Priority: 14.05.2025 US 202519208091
(71) Applicant: GlobalFoundries U.S. Inc., Malta, NY 12020 (US)
(72) Inventor: Awad, Ramy, Wilmington, 19801 (US); Mohamed Ali, Ahmed Hesham Elsayed, Wilmington, 19801 (US); Mahmoud, Mahmoud Salah Abdelrahim, Wilmington, 19801 (US); Mahmoud, Mohamed Ahmed Abdelazim, Wilmington, 19801 (US)
(74) Representative: Grünecker Patent- und Rechtsanwälte PartG mbB

(57) **Abstract**

The techniques described herein relate to systems, apparatus, articles of manufacture, and methods for bandwidth-enhanced differential transimpedance amplifiers. An example circuit includes a regulator, a transimpedance amplifier comprising an input, a capacitor comprising a first terminal and a second terminal, the first terminal coupled to the input, and an inductor comprising a first end and a second end, the first end coupled to the regulator and the second end coupled to the second terminal.

## Description

### FIELD

The techniques described herein relate generally to circuits and, more particularly, to bandwidth-enhanced differential transimpedance amplifiers.

### BACKGROUND

Data center networking demands are substantially increasing, driven by technologies such as fifth generation cellular (i.e., 5G), artificial intelligence and machine learning (AI/ML), cloud storage, Internet-of-Things (IoT), and video conferencing. Such technologies use high-bandwidth data links, which may include 100 gigabit/second (Gb/s) or greater capabilities over distances ranging from meters to kilometers.

Optical links may be used to implement these high-bandwidth data links by using an optical transmitter to transmit light through an optical medium, such as optical fibers, to an optical receiver. An optical receiver may include a photodetector and associated circuitry to detect and convert received light into an electrical signal for subsequent data communication processing.

### SUMMARY

In accordance with the disclosed subject matter, bandwidth-enhanced differential transimpedance amplifiers are disclosed.

Some embodiments relate to a circuit comprising a regulator, a transimpedance amplifier comprising an input, a capacitor comprising a first terminal and a second terminal, the first terminal coupled to the input, and an inductor comprising a first end and a second end, the first end coupled to the regulator and the second end coupled to the second terminal.

Some embodiments relate to a receiver circuit. The receiver circuit comprises a first transimpedance amplifier, a second transimpedance amplifier configured in parallel with the first transimpedance amplifier, the first transimpedance amplifier and the second transimpedance amplifier configured to convert at least one current output from a photodetector into a differential voltage, and a direct current (DC) blocking network configured with a cutoff frequency in the gigahertz range.

Some embodiments relate to an optical receiver. The optical receiver comprises a regulator, a direct current (DC) blocking network coupled to an output of the regulator, a photodetector coupled to the DC blocking network, a first transimpedance amplifier coupled to the DC blocking network, and a second transimpedance amplifier coupled to the photodetector, the first transimpedance amplifier and the second transimpedance amplifier configured to convert at least one current output from a photodetector into a differential voltage.

The foregoing summary is not intended to be limiting. Moreover, various aspects of the present disclosure may be implemented alone or in combination with other aspects.

### BRIEF DESCRIPTION OF FIGURES

Various aspects and embodiments of the present technology will be described with reference to the following figures. In the figures, each identical or nearly identical component that is illustrated in various figures is represented by a like reference character. For purposes of clarity, not every component may be labeled in every drawing. The drawings are not necessarily drawn to scale, with emphasis instead being placed on illustrating various aspects of the techniques and devices described herein.
FIG. 1 shows an example communication system including an optical receiver in an optical cable effectuating communication between networked computing devices, in accordance with some embodiments of the technology described herein.
FIG. 2 shows an example implementation of the optical receiver of FIG. 1 including transimpedance amplifiers configured in parallel, in accordance with some embodiments of the technology described herein.
FIG. 3A shows an annotated portion of the optical receiver of FIG. 2, in accordance with some embodiments of the technology described herein.
FIG. 3B shows graphs of example transimpedances with respect to input frequency associated with the transimpedance amplifiers of the optical receiver of FIGS. 2 and/or 3A, in accordance with some embodiments of the technology described herein.
FIG. 4 shows the optical receiver of FIGS. 2 and/or 3A coupled to an example common-source source-follower amplifier, in accordance with some embodiments of the technology described herein.
FIG. 5 shows waveforms representing example operation of the optical receiver of FIGS. 2 and/or 3A, in accordance with some embodiments of the technology described herein.
FIG. 6 is another example implementation of an optical receiver, in accordance with some embodiments of the technology described herein.

### DETAILED DESCRIPTION

The present application generally provides optical receivers that implement high-bandwidth communication links with improved signal integrity and noise performance compared to conventional optical receivers. Optical receivers disclosed herein may include transimpedance amplifiers (TIAs) configured in parallel to convert current output from a photodetector, which detects light from an optical medium, into a voltage. The TIAs may be configured with a differential shunt-feedback topology, which enhances signal-to-noise ratio (SNR) by at least 3 decibels (dB). Some such optical receivers may include a direct current (DC) blocking network configured to have a cutoff frequency in the gigahertz (GHz) range. Beneficially, such a DC blocking network (or DC blocker network) may boost the high frequency components of the current output by 6 dB compared to conventional single-ended TIAs.

In some embodiments, the GHz range (e.g., the GHz frequency range) includes frequency ranges in which the lower bound of the frequency ranges is 1 GHz or greater. Examples of the GHz range include a range of 1 GHz to 50 GHz, a range of 1 GHz to 60 GHz, a range of 10 GHz to 50 GHz, a range of 10 GHz to 60 GHz, and a range of 50 GHz to 60 GHz.

High-speed optical communication systems, particularly those supporting 224 GHz (224G) linear pluggable optics (LPO), demand high SNR while maintaining sufficient bandwidth for proper signal reconstruction. Such optical systems typically include TIAs to convert current output from a photodetector into a voltage. However, noise from TIAs limits the overall optical receiver sensitivity. The inventors have recognized that noise is highly sensitive to a resistance of a resistor in a feedback path (referred to as feedback resistance (Rf)) of the TIAs. The inventors have also recognized several technological challenges associated with using TIAs in high-speed optical communication systems discussed further below.

A conventional TIA design involves improving SNR by increasing feedback resistance (Rf) of the TIAs. However, the inventors have recognized that increasing Rf reduces bandwidth, which requires equalizing the limited bandwidth using continuous-time linear equalization (CTLE), feed-forward equalization (FFE), or decision-feedback equalization (DFE). The inventors have further recognized these equalization techniques consume area overhead and are complex, expensive, and power intensive at 224G operating frequencies.

Another conventional TIA design involves coupling cascaded low-dropout (LDO) regulators to TIAs configured in a differential arrangement to effectuate differential signaling. Differential TIAs enhance the SNR by 3 dB over single-ended designs. The 3 dB enhancement is based on a 6 dB gain improvement less a 3 dB noise increase (e.g., 3 dB = 6 dB gain improvement - 3 dB noise increase). However, the inventors have recognized that differential TIAs introduce limitations such as stacking complexity, limited photodetector bias, and asymmetric AC response leading to baseline wander (BLW). For example, the cascaded LDOs introduce implementation complexity, consume excess area overhead, and are power-intensive while also limiting photodetector bias. Additionally, the upper path of the differential TIAs is alternating current (AC) coupled, which introduces megahertz (MHz) range high-pass filtering and has an asymmetric AC response that also introduces baseline wander issues.

The inventors have developed technology that overcomes the above technological challenges associated with conventional TIA designs in high-speed optical communication systems. The inventors have developed an optical receiver including TIAs configured in parallel and each configured with a shunt-feedback topology. The TIAs are coupled to a DC blocking network having a cut-off frequency in the GHz range. The DC blocking network may include an inductor and a capacitor arranged in parallel. Beneficially, such an arrangement may turn the TIA in the upper path into an equalization "knob" or "tuner" that can be implemented relatively easily with reasonable inductor and capacitor sizes.

Additionally, the TIAs may be configured to boost the high frequency components by at least 6 dB compared to conventional single-ended TIAs. For example, the TIA in the upper path of the optical receiver may implement a high-pass filter and the TIA in the lower path of the optical receiver may implement a low-pass filter such that, together, the TIAs implement an all-pass filter. In such an example, the TIA in the lower path may provide gain to the input signal at lower frequencies and the TIAs in both the upper and lower path may provide gain to the input signal at higher frequencies to effectuate wide bandwidth differential signaling.

In some embodiments, the optical receiver developed by the inventors has reduced voltage overhead compared to conventional TIA designs. For example, the TIAs may be coupled to a single regulator compared to conventional TIA designs that have multiple LDO regulators. Beneficially, by reducing the voltage overhead, the optical receiver developed by the inventors enables increased voltage headroom for the photodetector while having a reduced area footprint (e.g., a smaller area footprint due to having a fewer number of regulators).

In some embodiments, the optical receiver developed by the inventors operates both TIAs under the same voltage supply domain. For example, by including a single regulator, the TIAs in the optical receiver operate under the same supply domain as the single regulator. Beneficially, operating under the same supply domain achieves further benefits such as having better common mode (CM) and power supply noise (PSN) rejection, eliminating the need for level shifters at the output of the TIAs, and improving the overall reliability of the optical receiver with respect to conventional designs.

The techniques described herein may be implemented in any of numerous ways, as the techniques are not limited to any particular manner of implementation. Examples of details of implementation are provided herein solely for illustrative purposes. Furthermore, the techniques disclosed herein may be used individually or in any suitable combination, as aspects of the technology described herein are not limited to the use of any particular technique or combination of techniques.

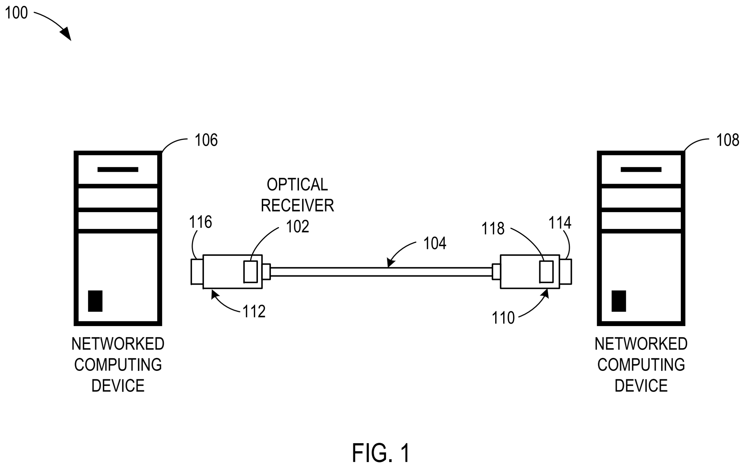

Turning to the figures, the illustrated example of FIG. 1 shows an example communication system 100 including an optical receiver 102 in an optical cable 104. The optical cable 104 can be used to effectuate communication between shown networked computing devices 106, 108, which include a first networked computing device 106 and a second networked computing device 108. For example, the optical cable 104 can be used to exchange data between the networked computing devices 106, 108 using optical signals over the optical cable 104.

As shown, the networked computing devices 106, 108 are servers (e.g., computer servers). Examples of servers include blade servers and rack-mounted servers. Additionally and/or alternatively, one(s) of the networked computing devices 106, 108 may be a desktop computer, a laptop computer, a tablet computer, a workstation, or any other type of computing and/or electronic device. Although only two networked computing devices 106, 108 are shown, more than two networked computing devices 106, 108 may be used to implement the communication system 100 of FIG. 1.

In some embodiments, the networked computing devices 106, 108 include at least one network interface configured to effectuate communication with at least one network. Examples of the at least one network interface include network interface circuitry, network interface cards (NICs), smart NICs, pluggable optical modules, and linear pluggable optics (LPO).

In some embodiments, the optical cable 104, the networked computing devices 106, 108, and/or, more generally, the communication system 100, may implement at least part of at least one network. The at least one network may be implemented by any wired and/or wireless network(s) such as one or more cellular networks (e.g., 4G LTE cellular networks, 5G cellular networks, future generation 6G cellular networks, etc.), one or more data buses, one or more local area networks (LANs), one or more data center networks, one or more optical fiber networks, one or more private networks, one or more public networks, one or more satellite networks, one or more wireless local area networks (WLANs), etc., and/or any combination(s) thereof. For example, the optical cable 104, the networked computing devices 106, 108, and/or, more generally, the communication system 100, may be part of a data center network. In such an example, the optical cable 104, the networked computing devices 106, 108, and/or, more generally, the communication system 100, may be in a data center.

In some embodiments, the at least one network interface can be configured to transmit and/or receive signals in accordance with a signal modulation technique. Examples of signal modulation techniques include amplitude modulation and coherent modulation.

Examples of amplitude modulation include Non-Return-to-Zero (NRZ) modulation (also referred to as two-level Pulse Amplitude Modulation), four-level Pulse-Amplitude Modulation (PAM4), six-level Pulse-Amplitude Modulation (PAM6), eight-level Pulse-Amplitude Modulation (PAM8), and sixteen-level Pulse-Amplitude Modulation (PAM16). For example, at least one network interface of the first networked computing device 106 can transmit PAM4 signals to at least one network interface of the second networked computing device 108 via the optical cable 104.

Examples of coherent modulation include 16-Quadrature Amplitude Modulation (16-QAM) and 64-Quadrature Amplitude Modulation (64-QAM). For example, at least one network interface of the first networked computing device 106 can transmit 64-QAM signals to at least one network interface of the second networked computing device 108 via the optical cable 104.

The optical cable 104 can include various types of fibers to transmit light. For example, the optical cable 104 can be a fiber optic cable, which uses thin glass fibers to transmit light. Examples of fiber optic cables include single-mode fiber (SMF), multimode fiber (MMF), armored fiber, OM1, OM4, ribbon, simplex fiber, and avionics cables.

The optical cable 104 shown includes a first connector 110 on a first side of the optical cable 104 and a second connector 112 on a second side of the optical cable 104, and the second side is opposite the first side. The connectors 110, 112 of this example are plugs (e.g., plug connectors) because they are configured to be plugged into a receptacle at the networked computing devices 106, 108. Alternatively, one or both connectors 110, 112 may be receptacles.

The connectors 110, 112 respectively include an electrical connector 114, 116. The electrical connectors 114, 116 may be high-density electrical connectors such that the electrical connectors 114, 116 include a plurality of contacts (e.g., pins, sockets) for connection to the networked computing devices 106, 108.

The optical cable 104 shown is an active optical pluggable that is configured to be plugged into a network device, such as at least one network interface of the networked computing devices 106, 108. For example, the optical cable 104 may be plugged into a first network interface (e.g., a network port) of the first networked computing device 106 and a second network interface (e.g., a network port) of the second networked computing device 108. In such an example, the second networked computing device 108 may output electrical signals to the first connector 110, the first connector 110 may convert the electrical signals into optical signals for transmission over the optical cable 104 to the second connector 112, and the second connector 112 may convert the optical signals back into electrical signals for output to the first networked computing device 106.

The optical cable 104 shown is an active optical cable (AOC). An AOC is a cable that uses circuitry to convert electrical signals to light and back again to achieve faster data transfer over longer distances. Examples of AOC circuitry include receivers (e.g., optical receivers), transmitters (e.g., optical transmitters), and transceivers (e.g., optical transceivers).

In the shown example, the first connector 110 includes an optical transmitter 118. Additionally and/or alternatively, the first connector 110 may include an optical receiver (e.g., an instance of the optical receiver 102) and/or an optical transceiver. The optical transmitter 118 can be implemented using circuitry configured to convert electrical signals received by the first electrical connector 114 into optical signals for transmission over the optical cable 104. For example, the optical transmitter 118 can convert electrical signals from at least one network interface of the second networked device 108 into optical signals for transmission over the optical cable 104.

In some embodiments, the optical transmitter 118 can implement and/or perform one or more signal conditioning techniques. Examples of signal conditioning techniques include DC offset removal, equalization, filtering, modulation, pre-amplification, and pre-emphasis. For example, the optical transmitter 118 can convert electrical PAM4 signals received from the second networked computing device 108 into an optical signal (e.g., light pulses) using a modulator and then transmit the optical signal through the optical cable 104. In such an example, the varying intensities of the optical signal can represent the different voltage levels of the PAM4 signal.

In some embodiments, the optical transmitter 118 can be implemented using at least one integrated circuit. Examples of an integrated circuit include an application specific integrated circuit (ASIC), a central processing unit (CPU), a digital signal processor (DSP), a field programmable gate array (FPGA), and a microcontroller.

In the shown example, the second connector 112 includes the optical receiver 102. Additionally and/or alternatively, the second connector 112 may include an optical transmitter (e.g., an instance of the optical transmitter 118) and/or an optical transceiver. The optical receiver 102 can be implemented using circuitry configured to convert optical signals transmitted by the optical transmitter 118 into electrical signals for output to the first networked computing device 106 via the second electrical connector 116.

In some embodiments, the optical receiver 102 can implement and/or perform one or more signal conditioning techniques. For example, the optical receiver 102 can implement and/or perform at least one of amplification (e.g., transimpedance amplification), DC offset removal, demodulation, equalization, or filtering. For example, the optical receiver 102 can use a photodetector to convert an optical signal received from the optical transmitter 118 into an electrical PAM4 signal that can be decoded to retrieve the data.

In some embodiments, the optical receiver 102 can be implemented using at least one integrated circuit. For example, the optical receiver 102 can be implemented using at least one of an ASIC, a CPU, a DSP, an FPGA, or a microcontroller.

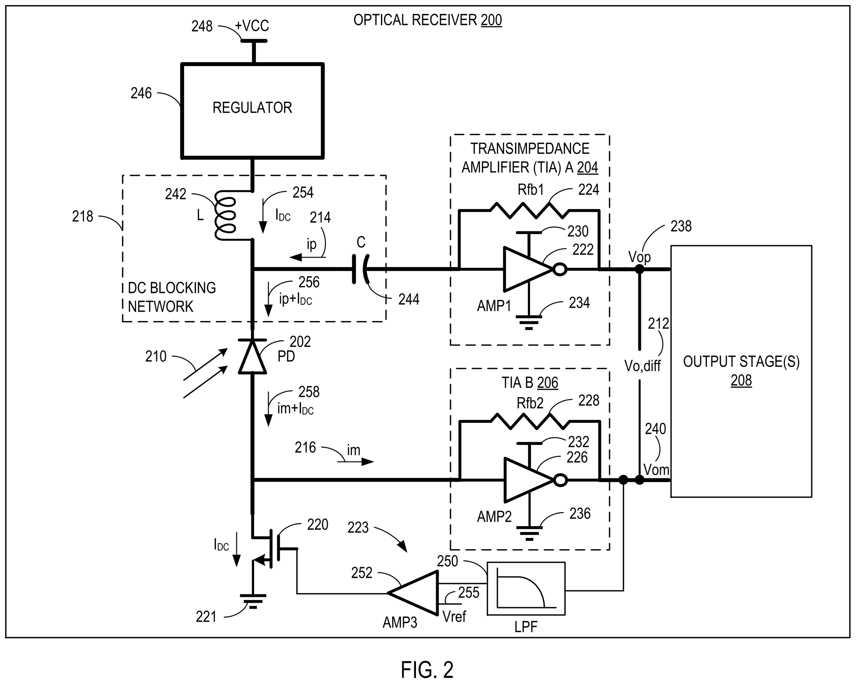

FIG. 2 shows an example optical receiver 200. In some embodiments, the optical receiver 200 of FIG. 2 can implement and/or correspond to the optical receiver 102 of FIG. 1. The optical receiver 200 shown is the front-end circuit of an optical receiver, which may also be referred to as an optical receiver front end.

In the illustrated example, the optical receiver 200 is implemented at least in part by a circuit. The circuit shown in FIG. 2 can be a receiver circuit and/or, more generally, a communication circuit. For example, the circuit shown in FIG. 2 can be at least one circuit configured for effectuating communication (e.g., wireline communication).

The optical receiver 200 is a wireline receiver. Examples of a wireline receiver include an Ethernet interface, a High-Definition Multimedia Interface (HDMI), a Peripheral Component Interconnect Express (PCIe) interface (e.g., an optical PCIe interface), an optical bus interface, and a co-packaged optics interface.

The optical receiver 200 includes a photodetector 202 (identified by "PD"), a first transimpedance amplifier (TIA) 204 (identified by "TIA A"), a second TIA 206 (identified by "TIA B"), and output stage(s) 208 to convert an optical signal 210 into an electrical signal 212 (identified by "Vo,diff") for data recovery. For example, the optical signal 210 can be light transmitted through the optical cable 104 of FIG. 1 by the optical transmitter 118 and received by the optical receiver 102.

In some embodiments, the optical signal 210 is modulated in accordance with PAM4 such that the intensities of the optical signal 210 represent the different voltage levels of PAM4. Alternatively, the optical signal 210 may be modulated in accordance with any other modulation technique such as NRZ modulation or higher level modulation such as PAM6, PAM8, or PAM16.

The optical receiver 200 shown in FIG. 2 is an example implementation. For example, the optical receiver 200 may be implemented using one or more dies of an integrated circuit, one or more integrated circuits, one or more printed circuit boards (PCBs), etc., and/or any combination(s) thereof. In some embodiments, the photodetector 202, the first TIA 204, the second TIA 206, and/or the output stage(s) 208 may be separate from the optical receiver 200 such that the optical receiver 200 may not include the photodetector 202, the first TIA 204, the second TIA 206, and/or the output stage(s) 208.

By way of example, the optical receiver 200 may be implemented using multiple dies of an integrated circuit. For example, the first and second TIAs 204, 206 may be on a first die of an integrated circuit and the output stage(s) 208 may be on a second die of the integrated circuit. In such an example, the photodetector 202 may be on the first die, the second die, a third die of the integrated circuit, or separate from the integrated circuit. Alternatively, the first and second TIAs 204, 206 may be on different dies of the integrated circuit.

By way of another example, the optical receiver 200 may be implemented using multiple integrated circuits. For example, the first and second TIAs 204, 206 may be included in a first integrated circuit and the output stage(s) 208 may be included in a second integrated circuit. In such an example, the photodetector 202 may be included in the first integrated circuit, the second integrated circuit, a third integrated circuit, or separate from the integrated circuits. Alternatively, the first and second TIAs 204, 206 may be on different integrated circuits.

By way of yet another example, the optical receiver 200 may be implemented using multiple PCBs. For example, the first and second TIAs 204, 206 may be included on a first PCB and the output stage(s) 208 may be included on a second PCB. In such an example, the photodetector 202 may be included on the first PCB, the second PCB, a third PCB, or separate from the PCBs. Alternatively, the first and second TIAs 204, 206 may be on different PCBs.

In the illustrated example of FIG. 2, the photodetector 202 is configured to convert the optical signal 210 into a first photocurrent 214 (identified by "ip") and a second photocurrent 216 (identified by "im"). The cathode of the photodetector 202 is coupled to a direct current (DC) blocking network 218 and the anode of the photodetector 202 is coupled to a switch 220 and the second TIA 206.

Components as described herein may be coupled to each via one or more electrical and/or optical connections. Examples of electrical connections include pads, traces, wires (e.g., interconnects), and vias. An example of an optical connection includes an opto-isolator. For example, the DC blocking network 218 and the photodetector 202 may be coupled together using at least one wire (e.g., at least one interconnect).

The photodetector 202 is a photodiode. Examples of photodiodes include P-N photodiodes, PIN photodiodes, and avalanche photodiodes. Alternatively, the photodetector 202 may be any other type of light detecting device that needs biasing (or reverse biasing), such as a phototransistor.

The first and second TIAs 204, 206 of the illustrated example can be and/or implement a differential TIA, such as a bandwidth-enhanced differential TIA. As shown, the first and second TIAs 204, 206 are configured in parallel and each are configured with a shunt-feedback topology to convert the photocurrents 214, 216 into the electrical signal 212. The electrical signal 212 is a differential signal, which in this example is a differential voltage.

The differential implementation of the first and second TIAs 204, 206 uses both terminals of the photodetector 202, thereby doubling the signal current without compromising noise performance. For example, an input of the first TIA 204 is coupled to a first photodetector terminal (e.g., the cathode) of the photodetector 202 through the DC blocking network 218 and an input of the second TIA 206 is coupled to a second photodetector terminal (e.g., the anode) of the photodetector 202. Beneficially, the first and second TIAs 204, 206 shown in FIG. 2 achieve a 3dB improvement in SNR, which is desirable in high-sensitivity optical receivers.

In some embodiments, the second TIA 206 operates at nearly the full bandwidth of the optical receiver 200. In some such embodiments, the second TIA 206 can be the "main" or "primary" TIA of the optical receiver 200. However, when the gain of the second TIA 206 decreases at higher frequencies, the first TIA 204 can begin to operate to maintain the gain of the optical receiver 200 at a relatively constant level. In some such embodiments, the first TIA 204 can be an "equalization" TIA such that the first TIA 204 can compensate for and/or otherwise equalize the drop in gain due to the second TIA 206.

The first TIA 204 includes a first amplifier 222 (identified by "AMP1") coupled to a first resistor 224 in a feedback arrangement. The first amplifier 222 is an inverting amplifier. Alternatively, the first TIA 204 may be implemented by using a different type of amplifier for the first amplifier 222.

The first resistor 224 has a resistance (e.g., a feedback resistance) Rfb1. An input of the first amplifier 222 and a first terminal of the first resistor 224 are coupled to the cathode of the photodetector 202 through the DC blocking network 218.

The second TIA 206 includes a second amplifier 226 (identified by "AMP2") coupled to a second resistor 228 in a feedback arrangement. The second amplifier 226 is an inverting amplifier. Alternatively, the second TIA 206 may be implemented by using a different type of amplifier for the second amplifier 226.

The second resistor 228 has a resistance (e.g., a feedback resistance) Rfb2. In some embodiments, Rfb1 is the same as Rfb2 (e.g., the same resistance in a tolerance range, such as +/- 1%, 3%, 5%) while in other embodiments they are different. An input of the second amplifier 226 and a first terminal of the second resistor 228 are coupled to (i) the anode of the photodetector 202 and (ii) a current terminal (e.g., a drain terminal) of the switch 220.

The switch 220 is a transistor. As shown, the switch 220 is an n-channel metal-oxide-semiconductor field-effect transistor (MOSFET) having a first current terminal (e.g., a drain terminal), a second current terminal (e.g., a source terminal), and a gate terminal. Alternatively, the switch 220 may be a different type of transistor. Examples of different types of transistors include a field-effect transistor (FET), a bipolar junction transistor (BJT) (e.g., an NPN BJT, a PNP BJT), and an insulated-gate bipolar transistor (IGBT). Examples of FETs include power FETs and MOSFETs (e.g., p-channel MOSFETs, n-channel MOSFETs, etc.).

The first current terminal of the switch 220 is coupled to the anode of the photodetector 202, the second resistor 228, and the input of the second amplifier 226. The second current terminal is coupled to a reference node 221 (e.g., electrical ground). The gate terminal is configured to be coupled to a DC current control (DCCC) loop 223.

To overcome the technical challenge of introducing baseline wandering as seen in conventional TIA implementations, the second TIA 206 uses the feedback resistor 228 in connection with the DCCC loop 223. Beneficially, this configuration restricts DC current through the feedback resistor 228 to ensure that substantially only the AC current contributes to the signal conversion. In some embodiments, as discussed further below, this configuration may maintain a high-pass corner frequency below a threshold frequency (e.g., 50 kilohertz (kHz), effectively suppressing low-frequency drift in signal data (e.g., PAM4 signal data).

In the illustrated example of FIG. 2, the DCCC loop 223 can be configured to adjust the second TIA 206 bias and operating point for optimized and/or otherwise improved performance. For example, the DCCC loop 223 can be configured such that if the output of the second TIA 206 has DC current, then the DCCC loop 223 creates countercurrent to subtract the DC current from the photodetector 202 to avoid blocking the optical receiver 200 with a large DC signal. In such an example, the DCCC loop 233 can be configured to create countercurrent in response to any DC current flowing through the second resistor 228.

The DCCC loop 223 includes at least the second amplifier 226, a filter 250 (identified by "LPF"), a third amplifier 252 (identified by "AMP3"), and the switch 220. The filter 250 is a low pass filter. Alternatively, the filter 250 may be a different type of filter. The third amplifier 252 is a differential amplifier. Alternatively, the third amplifier 252 may be a different type of amplifier.

In the illustrated example, a DC current 254 (identified by "I_{DC}") is shown that flows through the inductor 242 and the switch 220. The DCCC loop 223 controls the switch 220 to conduct such that the DC current 254 flows through the switch 220. Further shown is a first current 256 (identified by "ip+ I_{DC}"), which is composed of the first photocurrent 214 and the DC current 254, and a second current 258 (identified by "im+ I_{DC}") that is composed of the second photocurrent 216 and the DC current 254.

In example operation, the photodetector 202 converts the optical signal 210 into at least the second photocurrent 216. The second amplifier 226 converts the second photocurrent 216 into an output voltage, which is shown as the second voltage 240. The second voltage 240 is equal to the negative product of the second photocurrent 216 and the resistance of the second resistor 228. The second photocurrent 216 flows through the second resistor 228 and the second amplifier 226 adjusts its voltage output to keep its inputs at equal voltages. The current-to-voltage gain of the second amplifier 226 is based on the feedback resistance (e.g., resistance Rfb2) of the second resistor 228.

In example operation, in response to a threshold minimum amount of DC current (e.g., 0.01 milliamperes (mA), 0.1 mA, etc.) flowing through the second resistor 228, the third amplifier 252 outputs current (e.g., countercurrent) that corresponds to the DC current. For example, the second voltage 240 is output to the filter 250, which is configured to allow only relatively low frequencies to pass. In such an example, the filter 250 can have a corner frequency of 50 kHz. Alternatively, the filter 250 may have a different corner frequency, such as 10 kHz, 25 kHz, 75 kHz, or 100 kHz.

In example operation, the filter 250 outputs the second voltage 240 with frequencies less than the corner frequency to the third amplifier 252. The third amplifier 252 outputs a voltage proportional to a difference between (i) the output voltage from the filter 250 and (ii) a reference voltage 255 (identified by "Vref"). In some embodiments, the reference voltage 255 is constant. In some embodiments, the reference voltage 255 can be dynamically adjusted (e.g., by a controller).

As shown, the output voltage from the third amplifier 252 is output to a control terminal (e.g., a gate terminal) of the switch 220. For example, the output voltage from the third amplifier 252 can be a control voltage (e.g., a gate voltage) to control the switch 220.

By way of example, an increase in the output voltage can correspondingly decrease the DC current flowing from a regulator 246 through the switch 220. In such an example, larger DC currents flowing through the second resistor 228 can cause increased voltage output from the third amplifier 252, which reduces the DC current flowing through the switch 220 and thereby reduces the DC current flowing through the second resistor 228. Thus, the DCCC loop 223 can dynamically adjust (e.g., reduce) the DC current flowing through the second resistor 228 to adjust the bias of the second TIA 206 and subtract the DC current from the photodetector 202 to avoid blocking the optical receiver 200 with a large DC signal. Conversely, a decrease in the output voltage from the third amplifier 252 can correspondingly increase the current flowing through the switch 220.

The parallel differential shunt-feedback topology shown in FIG. 2 is implemented at least in part by configuring the amplifiers 222, 226 in parallel. As shown, a first power supply terminal of the first amplifier 222 is coupled to a first power supply 230 and a second power supply terminal of the second amplifier 226 is coupled to a second power supply 232.

In some embodiments, the first and second power supplies 230, 232 are the same. In some embodiments, the first and second power supplies 230, 232 are different.

The first power supply 230 and/or the second power supply 232 may output a voltage in a voltage range. The voltage may be in a voltage range of 0.8 V DC to 3 V DC. Another voltage range may be from 0.5 V DC to 4 V DC.

The first and second TIAs 204, 206 are configured in a differential arrangement to bias (e.g., reverse bias) the photodetector 202. For example, a differential voltage with respect to the power supplies 230, 232 and reference nodes 234, 236 can be used to reverse bias the photodetector 202.

The first and second TIAs 204, 206 are configured to convert the photocurrents 214, 216 into the electrical signal 212, which is a differential voltage. For example, the first amplifier 222 can be configured to convert and amplify the first photocurrent 214 into a first voltage 238 (identified by "Vop"). In such an example, the second amplifier 226 can be configured to convert and amplify the second photocurrent 216 into a second voltage 240 (identified by "Vom").

The difference between the first voltage 238 and the second voltage 240 together form the differential voltage 212 identified in FIG. 2 as Vo,diff (e.g., the difference between Vop and Vom). The differential voltage 212 is provided to the output stage(s) 208 for subsequent processing. For example, the output stage(s) 208 can include amplifiers (e.g., limiting amplifiers, variable gain amplifiers), filter(s), decision circuitry, and/or clock and data recovery (CDR) circuitry. In such an example, the output stage(s) 208 can include circuitry configured to convert the differential voltage 212 into PAM4 electrical signals (or any other signals such as NRZ, PAM6, PAM8, PAM16, 16-QAM, 64-QAM signals).

The optical receiver 200 includes the DC blocking network 218 to push and/or otherwise increase the cut-off frequency associated with the optical receiver 200 from the MHz range into the GHz range to enable high-frequency enhancement. Beneficially, the optical receiver 200 leverages AC coupling effects to boost high-frequency components by 6 dB, which significantly improves optical receiver performance at high data rates (e.g., 224G optical).

In some embodiments, the DC blocking network 218 includes inductor-capacitor (L-C) components sized to optimize and/or otherwise improve high-frequency equalization. As shown, the DC blocking network 218 includes an inductive element 242 and a charge storage element 244. The inductive element 242 is an inductor configured with an inductance L. The inductor 242 may be configured as a radio-frequency choke. The charge storage element 244 is a capacitor configured with a capacitance C.

The inductor 242 has a first end and a second end. The first end is coupled to the regulator 246. In some embodiments, the regulator 246 is a low-dropout (LDO) regulator configured to regulate an input voltage 248 (identified by "+VCC") into a regulated output to the inductor 242. In some such embodiments, the regulator 246 is not coupled to another regulator, which beneficially reduces power consumption and excess area overhead. The second end of the inductor 242 is coupled to the cathode of the photodetector 202 and a first terminal (e.g., a first capacitor terminal, a first plate, a first capacitor plate) of the capacitor 244. The capacitor 244 further has a second terminal (e.g., a second capacitor terminal, a second plate, a second capacitor plate), opposite the first terminal, and connected to the first resistor 224 and the input of the first amplifier 222.

In some embodiments, the capacitor 244 has a capacitance in the femtofarad range. For example, the capacitor 244 can have a capacitance of 100 femtofarads, 200 femtofarads, 300 femtofarads, 400 femtofarads, 500 femtofarads, etc.

In some embodiments, the input voltage 248 may be 3.3 V DC. In some embodiments, the input voltage 248 may be a different voltage such as 2.5 V DC, 3 V DC, 3.5 V DC, etc.

In some embodiments, the regulated output of the regulator 246 is 3 V DC. In some embodiments, the regulated output may be a different voltage such as 2.4 V DC, 2.7 V DC, 3.3 V DC, etc.

In some embodiments, the optical receiver 200 can be assembled, configured, designed, and/or manufactured to boost the very high frequency components by 6 dB compared to conventional single-ended TIAs. In some such embodiments, configuration of the DC blocking network 218 can turn the first TIA 204 into an equalization "knob" or "tuner" to achieve the desired bandwidth. For example, configuration and/or designing of the optical receiver 200 may begin with the second TIA 206. Rfb of the second resistor 228 may be increased by a factor of 2 to match the SNR of a differential TIA implementation. Such an increase in Rfb may achieve a gain increase of 6 dB, however, the bandwidth may drop by 50%. To compensate for the bandwidth reduction, the very high-frequency path of the optical receiver 200 may be tuned accordingly. For example, an inductance of the inductor 242 and/or a capacitance of the capacitor 244 may be selected to achieve the desired compensation in bandwidth reduction. In such an example, the first TIA 204 may act as a high-frequency gain stage, compensating for bandwidth limitations introduced by the increased Rfb in the second TIA 206.

The optical receiver 200 shown in the illustrated example of FIG. 2 achieves multiple benefits. First, using the regulator 246 instead of using multiple regulators reduces and/or avoids extra voltage overhead typically used in differential TIA designs. Beneficially, increased voltage headroom for the photodetector 202 can be achieved by avoiding the extra voltage overhead from using multiple regulators. For example, the optical receiver 200 shown in FIG. 2 can support wideband photodetectors with a bias requirement of 2 or more volts while maintaining a compact, power-efficient design. In such an example, the optical receiver 200 having the regulator 246 can be more compact and more power efficient than conventional optical receivers having multiple cascading LDO regulators by having fewer components than the conventional optical receivers.

Second, using the regulator 246 instead of using multiple regulators ensures that both TIAs 204, 206 operate under the same supply domain leading to several benefits. Such benefits include improved common mode (CM) and power supply noise (PSN) rejection, eliminating the need for level shifters at the output of the TIAs, and improving the overall reliability of the optical receiver with respect to conventional TIA designs.

While an example implementation of the optical receiver 200 is depicted in FIG. 2, other implementations are contemplated. For example, one or more blocks, components, functions, etc., of the optical receiver 200 may be combined or divided in any other way. The optical receiver 200 of the illustrated example may be implemented by hardware alone, or by a combination of hardware, software, and/or firmware. For example, the optical receiver 200 may be implemented by one or more analog circuits (e.g., capacitors, comparators, diodes, inductors, operational amplifiers, resistors, transistors, etc.), one or more digital circuits (e.g., logic gates, etc.), one or more hardware-implemented state machines, one or more programmable processors, one or more application specific integrated circuits (ASICs), etc., and/or any combination(s) thereof. The optical receiver 200 of the illustrated example can be implemented by one or more integrated circuits (ICs) on the same die or one or more ICs on two or more different dies, such as one or more ICs on a first die and one or more ICs on a second die.

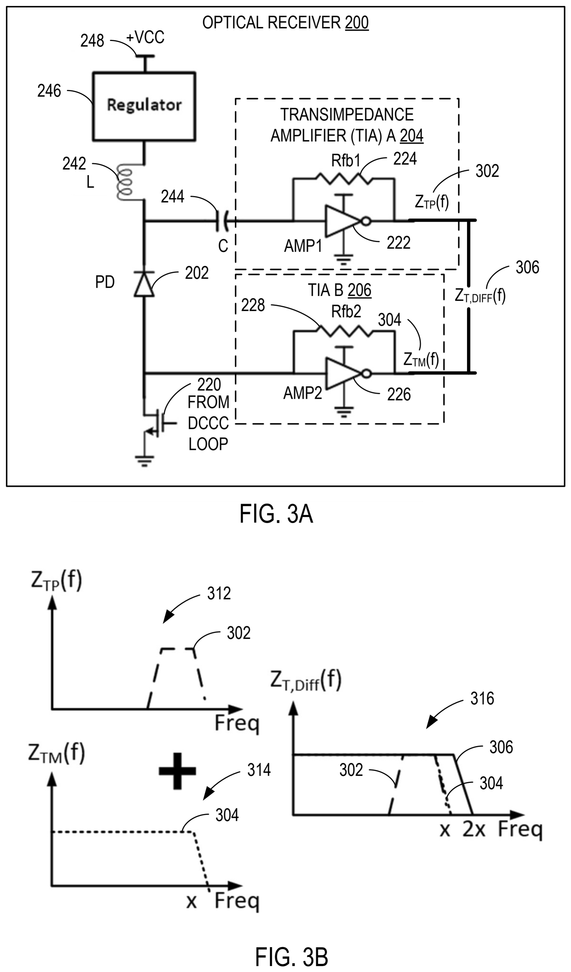

FIG. 3A shows an annotated implementation of the optical receiver 200 of FIG. 2, which omits some reference numerals from FIG. 2 for enhanced clarity. As shown in FIG. 3A, the first TIA 204 has a first transimpedance response 302 (identified by "Z_{TP}(f)") and the second TIA 206 has a second transimpedance response 304 (identified by "Z_{TM}(f)"). For example, an output of the first TIA 204 can have the first transimpedance response 302 and an output of the second TIA 206 can have the second transimpedance response 304. In FIG. 3A, a combination of the first and second TIAs 204, 206 has a third transimpedance response 306 (identified by "Z_{T,DIFF}(f)").

FIG. 3B shows the first transimpedance response 302, the second transimpedance response 304, and the third transimpedance response 306 associated with the implementation of the optical receiver 102 of FIG. 1 shown in FIGS 2 and/or 3A.

The first transimpedance response 302 is shown in a first graph 312 representing a gain of the first TIA 204 with respect to an input frequency to the first TIA 204. The second transimpedance response 304 is shown in a second graph 314 representing a gain of the second TIA 206 with respect to an input frequency to the second TIA 206. The third transimpedance response 306 is shown in a third graph 316 representing a gain of a combination of the first and second TIAs 204, 206 with respect to an input frequency to the first and second TIAs 204, 206.

In some embodiments, the first TIA 204 and the second TIA 206 can be configured the same. For example, as shown in the third graph 316, the third transimpedance response 306 associated with the first and second TIAs 204, 206 can be double at full bandwidth (identified by "2X" in the third graph 316) with respect to the second transimpedance response 304 of the second TIA 206 at full bandwidth (identified by "X" in the second graph 314).

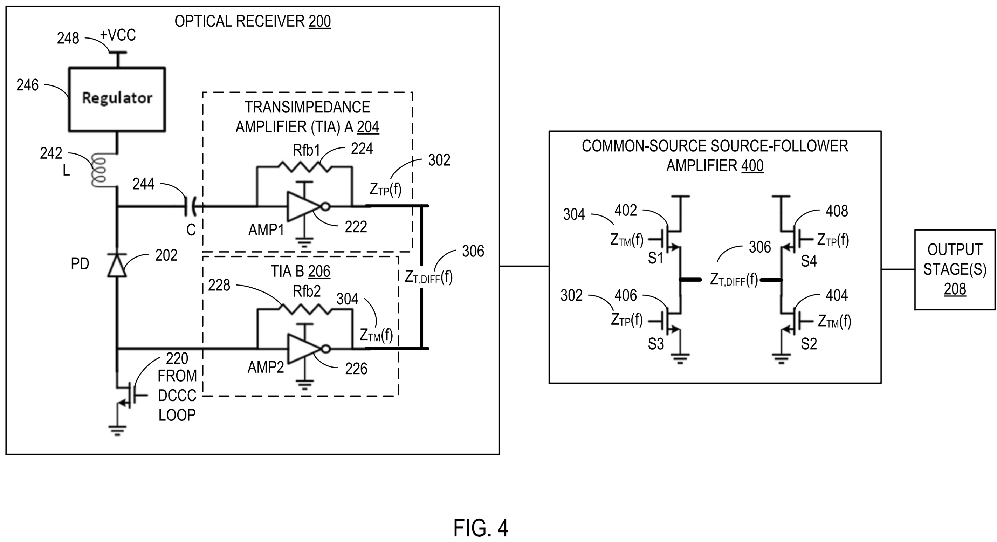

FIG. 4 shows the optical receiver 200 of FIGS. 2 and/or 3A coupled to an example common-source source-follower (CS-SF) amplifier 400. For example, outputs of the optical receiver 200 can be coupled to the CS-SF amplifier 400.

Further, as shown in FIG. 4, output(s) of the CS-SF amplifier 400 is/are coupled to input(s) of the output stage(s) 208. For example, the differential signal 212 of FIG. 2 can be output to the output stage(s) 208. In some such embodiments, the differential signal 212 can have the third transimpedance response 306 of FIG. 3A.

The CS-SF amplifier 400 in the illustrated example is implemented by a first switch 402 (identified by "S1"), a second switch 404 (identified by "S2"), a third switch 406 (identified by "S3"), and a fourth switch 408 (identified by "S4"). As shown, the switches 402, 404, 406, 408 are transistors and, more particularly, n-channel MOSFETs. Alternatively, one(s) of the switches 402, 404, 406, 408 may be a different type of transistor. Examples of the different types of transistors include a FET, a BJT, and an IGBT.

As shown, a source terminal of the first switch 402 is coupled to a drain terminal of drain terminal of the third switch 406. Also shown, a source terminal of the fourth switch 408 is coupled to a drain terminal of the second switch 404.

The first switch 402 and the fourth switch 408 can be configured to form an SF amplifier. The second switch 404 and the third switch 406 can be configured to form a CS amplifier. Thus, the first through fourth switches 402, 404, 406, 408 together can be configured to form the CS-SF amplifier 400.

In some embodiments, the CS-SF amplifier 400 operates differently in different frequency ranges. For example, for low-to-mid frequencies (e.g., frequencies in a range from 50 kHz to 10 GHz), the CS-SF amplifier 400 can operate as a single-ended to differential (S2D) converter, where one branch (e.g., the first switch 402 or fourth switch 408) operates as a SF amplifier (e.g., a noninverting amplifier) and the other branch (e.g., the second switch 404 or the third switch 406) operates as a CS amplifier (e.g., an inverting amplifier). In some such embodiments, the CS-SF amplifier 400 can operate to ensure a differential output with opposite phase components. In some embodiments, the low-to-mid frequencies can be frequencies less than the roll-off frequency and/or the cut-off frequency associated with the optical receiver 200.

Furthering the above example, for high frequencies (e.g., frequencies in a range from 10 GHz to 60 GHz), the CS-SF amplifier 400 can operate to become fully differential as both TIA outputs (e.g., Z_{TP} and Z_{TM}) become available. In some embodiments, the high frequencies can be frequencies greater than the roll-off frequency and/or the cut-off frequency associated with the optical receiver 200.

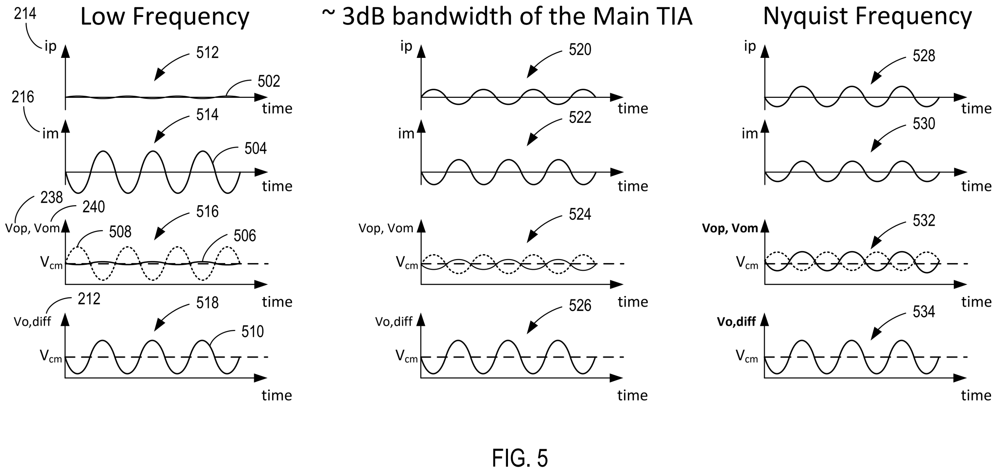

FIG. 5 shows graphs including waveforms 502, 504, 506, 508, 510 representing example operation of the optical receiver 200 of FIGS. 2, 3A, and/or 4 at different frequencies. The different frequencies include frequencies in a low frequency range, frequencies around approximately 3 dB bandwidth (e.g., the cut-off frequency) of the main TIA (e.g., the second TIA 206), and the Nyquist frequency. Frequencies in the low frequency range can be frequencies less than the roll-off and/or cut-off frequency associated with the optical receiver 200.

The waveforms 502, 504, 506, 508, 510 include first through fifth waveforms 502, 504, 506, 508, 510. The first waveform 502 represents the first photocurrent 214 of FIG. 2 with respect to time. The second waveform 504 represents the second photocurrent 216 of FIG. 2 with respect to time. The third waveform 506 represents the first voltage 238 of FIG. 2 with respect to time. The fourth waveform 508 represents the second voltage 240 of FIG. 2 with respect to time. The fifth waveform 510 represents the differential signal 212 of FIG. 2 with respect to time.

In FIG. 5, graphs 512, 514, 516, 518 correspond to the optical receiver 200 operating at low frequency. As shown in graphs 512, 514, 516, 518, the lower path of the optical receiver 200, which includes the second TIA 206 configured as the main or primary TIA, is contributing substantially more to the differential signal 212 than contributed by the upper path, which includes the first TIA 204 configured as the equalization or secondary TIA. For example, the second photocurrent 216 and the second voltage 240 are at relatively full strength while the first photocurrent 214 and the first voltage 238 are at relatively minimum strength.

In FIG. 5, graphs 520, 522, 524, 526 correspond to the optical receiver 200 operating at the cut-off frequency of the second TIA 206. As shown in graphs 520, 522, 524, 526, the lower path of the optical receiver 200, which includes the second TIA 206, is contributing less to the differential signal 212 when compared to the optical receiver 200 operating at low frequency and the upper path, which includes the first TIA 204, is contributing more to the differential signal 212 when compared to the optical receiver 200 operating at low frequency. For example, the first photocurrent 214 and the first voltage 238 are greater in the graphs 520, 524 with respect to the graphs 512, 516. Furthering the example, the second photocurrent 216 and the second voltage 240 are less in the graphs 522, 524 with respect to graphs 514, 516. Furthering the example, the differential signal 212 is approximately the same in the graph 526 with respect to the graph 518.

In FIG. 5, graphs 528, 530, 532, 534 correspond to the optical receiver 200 operating at the Nyquist frequency. As shown in graphs 528, 530, 532, 534, the lower path of the optical receiver 200, which includes the second TIA 206, is contributing less to the differential signal 212 when compared to the optical receiver 200 operating at the cut-off frequency of the second TIA 206 and the upper path, which includes the first TIA 204, is contributing more to the differential signal 212 when compared to the optical receiver 200 operating at the cut-off frequency of the second TIA 206. For example, the first photocurrent 214 and the first voltage 238 are greater in the graphs 528, 532 with respect to the graphs 520, 524. Furthering the example, the second photocurrent 216 and the second voltage 240 are less in the graphs 530, 532 with respect to graphs 522, 524. Furthering the example, the differential signal 212 is approximately the same in the graph 534 with respect to the graphs 518, 526.

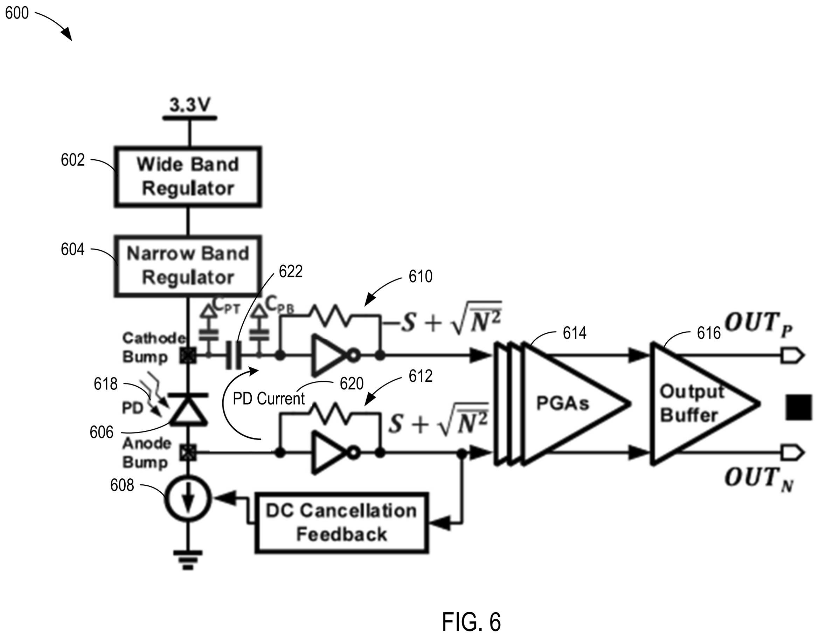

FIG. 6 is an example implementation of an optical receiver 600. The optical receiver 600 includes first and second regulators 602, 604, a photodetector 606, a current source 608, first and second TIAs 610, 612, multiple programmable gain amplifiers (PGAs), 614, and an output buffer 616. In example operation, the TIAs 610, 612 convert an optical signal 618 into photodetector current 620 (identified by "PD Current"). The TIAs 610, 612 convert the photodetector current 620 into a differential voltage.

The TIAs 610, 612 shown in FIG. 6 implement a differential TIA that enhances SNR by 3 dB over single-ended designs. The 3 dB enhancement is based on a 6 dB gain improvement less a 3 dB noise increase (e.g., 3 dB = 6 dB gain improvement - 3 dB noise increase).

However, the inventors have recognized that the optical receiver 600 has several drawbacks. First, the multiple, cascaded regulators 602, 604 consume excess area overhead, and are power-intensive while also limiting photodetector bias. Second, the upper path of the differential TIA (e.g., the path including the TIA 610) is AC coupled with a cut-off frequency in the MHz range, which introduces MHz range high-pass filtering and has an asymmetric AC response that also introduces baseline wander issues. Third, the upper path includes a capacitor 622 having a relatively large capacitance of 1 picofarads (pF), 5 pF, or 10 pF.

The optical receivers disclosed herein, such as the optical receiver 102 of FIG. 1 and/or the optical receiver 200 of FIGS. 2 and/or 3, overcome the above-discussed drawbacks. For example, the configuration of the optical receiver 200 eliminates the need for multiple regulators and instead includes a single regulator (e.g., the regulator 246). Beneficially, by eliminating additional regulators, the optical receiver 200 has reduced area overhead, reduced implementation complexity, and consumes less power than the optical receiver 600 of FIG. 6. Additionally, the configuration of the optical receiver 200 pushes the cut-off frequency from the MHz cut-off frequency into the GHz range. Beneficially, the optical receiver 200 having a GHz-range cut-off frequency enables a symmetric AC response and reduces and/or eliminates baseline wander issues. Further, the capacitance of the capacitor 622 is magnitudes larger than the capacitance of the capacitor 244, which consumes excess area overhead with respect to the optical receiver 200.

Embodiments have been described where the techniques are implemented in circuitry. It should be appreciated that some embodiments may be in the form of a method, of which at least one example has been provided. The acts performed as part of the method may be ordered in any suitable way. Accordingly, embodiments may be constructed in which acts are performed in an order different than illustrated, which may include performing some acts simultaneously, even though shown as sequential acts in illustrative embodiments.

Various aspects of the embodiments described above may be used alone, in combination, or in a variety of arrangements not specifically discussed in the embodiments described in the foregoing and is therefore not limited in its application to the details and arrangement of components set forth in the foregoing description or illustrated in the drawings. For example, aspects described in one embodiment may be combined in any manner with aspects described in other embodiments.

The phrase "and/or," as used herein in the specification and in the claims, should be understood to mean "either or both," of the elements so conjoined, e.g., elements that are conjunctively present in some cases and disjunctively present in other cases. Multiple elements listed with "and/or" should be construed in the same fashion, e.g., "one or more" of the elements so conjoined. Other elements may optionally be present other than the elements specifically identified by the "and/or" clause, whether related or unrelated to those elements specifically identified. Thus, as a non-limiting example, a reference to "A and/or B," when used in conjunction with open-ended language such as "comprising" can refer, in one embodiment, to A only (optionally including elements other than B); in another embodiment, to B only (optionally including elements other than A); in yet another embodiment, to both A and B (optionally including other elements); etc.

The indefinite articles "a" and "an," as used herein in the specification and in the claims, unless clearly indicated to the contrary, should be understood to mean "at least one."

As used herein in the specification and in the claims, the phrase, "at least one," in reference to a list of one or more elements, should be understood to mean at least one element selected from any one or more of the elements in the list of elements, but not necessarily including at least one of each and every element specifically listed within the list of elements and not excluding any combinations of elements in the list of elements. This definition also allows that elements may optionally be present other than the elements specifically identified within the list of elements to which the phrase "at least one" refers, whether related or unrelated to those elements specifically identified. Thus, as a non-limiting example, "at least one of A and B" (or, equivalently, "at least one of A or B," or, equivalently, "at least one of A and/or B") can refer, in one embodiment, to at least one, optionally including more than one, A, with no B present (and optionally including elements other than B); in another embodiment, to at least one, optionally including more than one, B, with no A present (and optionally including elements other than A); in yet another embodiment, to at least one, optionally including more than one, A, ,and at least one, optionally including more than one, B (and optionally including other elements); etc.

Use of ordinal terms such as "first," "second," "third," etc., in the claims to modify a claim element does not by itself connote any priority, precedence, or order of one claim element over another or the temporal order in which acts of a method are performed, but are used merely as labels to distinguish one claim element having a certain name from another element having a same name (but for use of the ordinal term) to distinguish the claim elements.

Also, the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

Having thus described several aspects of at least one embodiment, it is to be appreciated that various alterations, modifications, and improvements will readily occur to those skilled in the art. Such alterations, modifications, and improvements are intended to be part of this disclosure and are intended to be within the spirit and scope of the principles described herein. Accordingly, the foregoing description and drawings are by way of example only.

In summary, the techniques described herein relate to systems, apparatus, articles of manufacture, and methods for bandwidth-enhanced differential transimpedance amplifiers. An example circuit includes a regulator, a transimpedance amplifier comprising an input, a capacitor comprising a first terminal and a second terminal, the first terminal coupled to the input, and an inductor comprising a first end and a second end, the first end coupled to the regulator and the second end coupled to the second terminal.
The following embodiments are explicitly disclosed.

### Embodiment 1:

A circuit comprising:
a regulator;
a transimpedance amplifier comprising an input;
a capacitor comprising a first terminal and a second terminal, the first terminal coupled to the input; and
an inductor comprising a first end and a second end, the first end coupled to the regulator and the second end coupled to the second terminal.
In some illustrative examples of embodiment 1, the circuit may comprise a DC blocking network comprising the inductor and the capacitor, the DC blocking network being configured with a cutoff frequency in the gigahertz range.

### Embodiment 2:

The circuit of embodiment 1, wherein the transimpedance amplifier is a first transimpedance amplifier, and further comprising a second transimpedance amplifier configured in parallel with the first transimpedance amplifier.

### Embodiment 3:

The circuit of embodiment 2, further comprising a photodetector, and wherein the first and second transimpedance amplifiers are configured to convert at least one current output from the photodetector into a differential voltage.

### Embodiment 4:

The circuit of embodiment 3, wherein the differential voltage corresponds to a Pulse Amplitude Modulation (PAM), a Non-Return-to-Zero (NRZ), or a Quadrature Amplitude Modulation (QAM) signal.

### Embodiment 5:

The circuit of embodiment 3 or 4, wherein the photodetector comprises a first photodetector terminal and a second photodetector terminal, the input of the first transimpedance amplifier is configured to be coupled to the first photodetector terminal through the capacitor, and the input of the second transimpedance amplifier is configured to be coupled to the second photodetector terminal.

### Embodiment 6:

The circuit of embodiment 5, wherein the photodetector is a photodiode, the first photodetector terminal is a cathode of the photodiode, and the second photodetector terminal is an anode of the photodiode.

### Embodiment 7:

The circuit of one of embodiments 3 to 6, further comprising a transistor coupled to the photodetector and the second transimpedance amplifier.

### Embodiment 8:

The circuit of one of embodiments 2 to 7, further comprising:
a first resistor coupled to the input and an output of the first transimpedance amplifier; and
a second resistor coupled to an input and an output of the second transimpedance amplifier.

### Embodiment 9:

The circuit of one of embodiments 1 to 8, wherein the inductor is a radio-frequency choke.

### Embodiment 10:

The circuit of one of embodiments 1 to 9, wherein the inductor has an inductance, the capacitor has a capacitance, and the inductance and the capacitance cause a cutoff frequency associated with the circuit to be in a range of 1 gigahertz to 60 gigahertz.

### Embodiment 11:

The circuit of one of embodiments 1 to 10, further comprising a common-source source-follower amplifier coupled to an output of the first transimpedance amplifier and an output of the second transimpedance amplifier.

### Embodiment 12:

The circuit of embodiment 11, further comprising at least one output stage coupled to an output of the common-source source-follower amplifier.

### Embodiment 13:

A receiver circuit comprising:
a first transimpedance amplifier;
a second transimpedance amplifier configured in parallel with the first transimpedance amplifier, the first transimpedance amplifier and the second transimpedance amplifier configured to convert at least one current output from a photodetector into a differential voltage; and
a direct current (DC) blocking network configured with a cutoff frequency in the gigahertz range.

### Embodiment 14:

The receiver circuit of embodiment 13, further comprising the photodetector.

### Embodiment 15:

The receiver circuit of embodiment 14, wherein the DC blocking network is coupled to an input of the first transimpedance amplifier and the photodetector.

### Embodiment 16:

The receiver circuit of one of embodiments 13 to 15, wherein the DC blocking network comprises:
an inductor comprising a first end and a second end; and
a capacitor comprising a first terminal and a second terminal, the first terminal coupled to the first end and the second terminal coupled to an input of the first transimpedance amplifier.
In some illustrative examples of embodiment 13, the receiver circuit of embodiment 13 may be identified with a combination of embodiments 1 to 3 such that any of embodiments 13 to 16 may refer back to any of embodiments 1 to 12 combined with embodiments 2 and 3.

### Embodiment 17:

An optical receiver comprising:
a regulator;
a direct current (DC) blocking network coupled to an output of the regulator;
a photodetector coupled to the DC blocking network;
a first transimpedance amplifier coupled to the DC blocking network; and
a second transimpedance amplifier coupled to the photodetector, the first transimpedance amplifier and the second transimpedance amplifier configured to convert at least one current output from a photodetector into a differential voltage.
In some illustrative examples herein, the first and second transimpedance amplifierts may be coupled in parallel to each other.
In some other illustrative examples herein, the second transimpedance amplifier may be configured to convert at least one current output from the photodetector into a differential voltage.

### Embodiment 18:

The optical receiver of embodiment 17, further comprising:
a low-pass filter comprising an input and an output, the input coupled to an output of the second transimpedance amplifier;
an amplifier comprising an input and an output, the input coupled to the output of the low-pass filter; and
a switch comprising a gate terminal and a current terminal, the gate terminal coupled to the output of the amplifier, and the current terminal coupled to the photodetector.

### Embodiment 19:

The optical receiver of embodiment 17 or 18, further comprising one or more output stages to convert the differential voltage into a Pulse Amplitude Modulation (PAM), a Non-Return-to-Zero (NRZ), or a Quadrature Amplitude Modulation (QAM) signal.
Embodiment 20: The optical receiver of one of embodiments 17 to 20, further comprising a common-source source-follower amplifier coupled to at least one of an output of the first transimpedance amplifier or an output of the second transimpedance amplifier.
In some illustrative examples of embodiment 17, the optical receiver circuit of embodiment 17 may be identified with a combination of embodiments 1 to 3 such that any of embodiments 18 to 20 may refer back to any of embodiments 1 to 12 combined with embodiments 2 and 3 and/or to any of embodiments 14 to 16.

## Claims

1. A circuit comprising:
a regulator;
a transimpedance amplifier comprising an input;
a capacitor comprising a first terminal and a second terminal, the first terminal coupled to the input; and
an inductor comprising a first end and a second end, the first end coupled to the regulator and the second end coupled to the second terminal.

2. The circuit of claim 1, wherein the transimpedance amplifier is a first transimpedance amplifier, and further comprising a second transimpedance amplifier configured in parallel with the first transimpedance amplifier.

3. The circuit of claim 2, further comprising a photodetector, and wherein the first and second transimpedance amplifiers are configured to convert at least one current output from the photodetector into a differential voltage.

4. The circuit of claim 3, wherein the differential voltage corresponds to a Pulse Amplitude Modulation (PAM), a Non-Return-to-Zero (NRZ), or a Quadrature Amplitude Modulation (QAM) signal; and/or
wherein the circuit further comprises a transistor coupled to the photodetector and the second transimpedance amplifier

5. The circuit of claim 3 or 4, wherein the photodetector comprises a first photodetector terminal and a second photodetector terminal, the input of the first transimpedance amplifier is configured to be coupled to the first photodetector terminal through the capacitor, and the input of the second transimpedance amplifier is configured to be coupled to the second photodetector terminal.

6. The circuit of claim 5, wherein the photodetector is a photodiode, the first photodetector terminal is a cathode of the photodiode, and the second photodetector terminal is an anode of the photodiode.

7. The circuit of one of claims 2 to 6, further comprising:
a first resistor coupled to the input and an output of the first transimpedance amplifier; and
a second resistor coupled to an input and an output of the second transimpedance amplifier.

8. The circuit of one of claims 1 to 7, wherein the inductor is a radio-frequency choke; and/or
wherein the inductor has an inductance, the capacitor has a capacitance, and the inductance and the capacitance cause a cutoff frequency associated with the circuit to be in a range of 1 gigahertz to 60 gigahertz.

9. The circuit of one of claims 1 to 8, further comprising a common-source source-follower amplifier coupled to an output of the first transimpedance amplifier and an output of the second transimpedance amplifier.

10. The circuit of claim 9, further comprising at least one output stage coupled to an output of the common-source source-follower amplifier.

11. A receiver circuit comprising:
a first transimpedance amplifier;
a second transimpedance amplifier configured in parallel with the first transimpedance amplifier, the first transimpedance amplifier and the second transimpedance amplifier configured to convert at least one current output from a photodetector into a differential voltage; and
a direct current (DC) blocking network configured with a cutoff frequency in the gigahertz range.

12. The receiver circuit of claim 11, wherein the receiver circuit further comprises the photodetector, wherein the DC blocking network preferably is coupled to an input of the first transimpedance amplifier and the photodetector; and/or
wherein the DC blocking network comprises:
an inductor comprising a first end and a second end, and
a capacitor comprising a first terminal and a second terminal, the first terminal coupled to the first end and the second terminal coupled to an input of the first transimpedance amplifier.

13. An optical receiver comprising:
a regulator;
a direct current (DC) blocking network coupled to an output of the regulator;
a photodetector coupled to the DC blocking network;
a first transimpedance amplifier coupled to the DC blocking network; and
a second transimpedance amplifier coupled to the photodetector, the first transimpedance amplifier and the second transimpedance amplifier configured to convert at least one current output from a photodetector into a differential voltage.

14. The optical receiver of claim 13, further comprising:
a low-pass filter comprising an input and an output, the input coupled to an output of the second transimpedance amplifier;
an amplifier comprising an input and an output, the input coupled to the output of the low-pass filter; and
a switch comprising a gate terminal and a current terminal, the gate terminal coupled to the output of the amplifier, and the current terminal coupled to the photodetector.

15. The optical receiver of claim 13 or 14, further comprising at least one of:
one or more output stages to convert the differential voltage into a Pulse Amplitude Modulation (PAM), a Non-Return-to-Zero (NRZ), or a Quadrature Amplitude Modulation (QAM) signal; and
a common-source source-follower amplifier coupled to at least one of an output of the first transimpedance amplifier or an output of the second transimpedance amplifier.
